# EUROPEAN PATENT SPECIFICATION

(11) **EP 1 732 132 B1**
(45) Date of publication and mention of the grant of the patent: **23.12.2009**
(21) Application number: 05012136.7
(22) Date of filing: 06.06.2005
(51) Int. Cl.: H01L 25/075

(54) **Method for packaging an array-type modularized light-emitting diode structure**
Verfahren zur Verpackung einer matrixartigen modularisierten LED-Struktur
Procédé pour l'encapsulation d'une structure modulaire de diodes électroluminescentes du type réseau

(43) Date of publication of application: 13.12.2006
(73) Proprietor: Tsou, Ching-Fu, Tanzih Township Taichung County 427 (TW); Chen, I-Ju, Chiayi City 600 (TW); Chao, Yeh-Chin, Hsinchu City 300 (TW)
(72) Inventor: Tsou, Ching-Fu, Tanzih Township Taichung County 427 (TW); Chen, I-Ju, Chiayi City 600 (TW); Chao, Yeh-Chin, Hsinchu City 300 (TW)
(74) Representative: Strehl Schübel-Hopf & Partner

(56) References cited:
- WO-A-2004/084319
- US-B1- 6 208 078
- US-B1- 6 614 103
- PATENT ABSTRACTS OF JAPAN vol. 1999, no. 11, 30 September 1999 (1999-09-30) -& JP 11 161197 A (MATSUSHITA ELECTRIC IND CO LTD), 18 June 1999 (1999-06-18)
- PATENT ABSTRACTS OF JAPAN vol. 2002, no. 12, 12 December 2002 (2002-12-12) -& JP 2002 232017 A (KYOCERA CORP), 16 August 2002 (2002-08-16)
- PATENT ABSTRACTS OF JAPAN vol. 011, no. 227 (E-526), 23 July 1987 (1987-07-23) -& JP 62 043139 A (OLYMPUS OPTICAL CO LTD), 25 February 1987 (1987-02-25)

## Description

### BACKGROUND OF THE INVENTION

The present invention is related to an array-type modularized light-emitting diode structure and a method for packaging the structure. In the modularized light-emitting diode structure, multiple light-emitting diodes are arranged in an array.

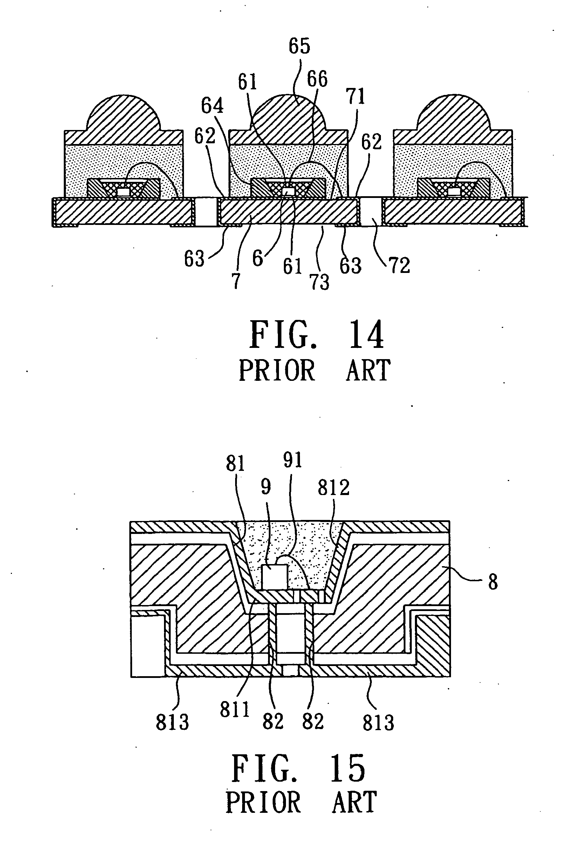

Fig. 14 shows the packaging structure of a conventional light-emitting diode. The bottom electrode **61** of the light-emitting diode crystallite **6** is electrically adhered to a first metal electrode layer **62.** The top electrode **61** of the light-emitting diode crystallite **6** via a conductive wire **66** is connected to another first metal electrode layer **62.** The two first metal electrode layers **62** are both disposed on upper face **71** of a fiberglass substrate **7** and respectively connected to two second metal electrode layers **63** under lower face **73** of the fiberglass substrate **7** through perforations **72.** Each light-emitting diode crystallite **6** is surrounded by a bowl-shaped reflective board **64** for focusing and upward reflecting the light emitted by the light-emitting diode crystallite **6.** The bowl-shaped reflective board **64** is enclosed by a packaging resin layer **65** for protecting the light-emitting diode crystallite **6** and the conductive wire **66.** Then the structure is cut along the center of the perforation **72.**

When emitting light, the light-emitting diode will generate heat. Therefore, the lighting efficiency of the light-emitting diode is affected by the heat dissipating capability. The substrate **7** of the packaging structure of the conventional light-emitting diode is an insulator having poor heat dissipating capability. Moreover, the substrate **7** is enclosed by the first metal electrode layers **62** and second metal electrode layers **63.** Therefore, it is hard for the heat generated by the light-emitting diode to dissipate from the substrate **7.** The heat can only partially dissipate via the metal electrode layers **62, 63** exposed to outer side of the packaging resin layer **65.** Therefore, the heat dissipation effect is very poor.

In order to solve the above problem, another type of packaging structure of light-emitting diode has been developed as shown in Fig. 15. A silicon chip serves as a substrate **8** which is formed with a depression **81** by means of exposure and development and wet etching. Then the bottom of the depression **81** is formed with two electrode guide through holes **82** by means of dry etching or laser. Then an insulating layer is formed on the surface of the substrate **8** by means of oxidization or nitrification. Then a metal layer is deposited on the insulating layer to form a metal electrode **811** and a reflective layer **812** in the depression **81** and form a back electrode layer **813** on the back face of the substrate **8.** The metal electrode **811** in the depression is cut into positive and negative electrode faces by means of laser. Then, the light-emitting diode crystallite 9 is placed on the positive electrode face in the depression **81** and connected to the negative electrode face via a conductive wire **91.** Then the depression **81** is point-packaged by resin. Finally, the structure is cut along a line between two depressions **81.**

The substrate **8** is a silicon chip which has better heat dissipating effect. Moreover, the depression **81** in which the light-emitting diode crystallite **9** is placed is directly formed in the substrate **8** so that the heat generated by the light-emitting diode crystallite **9** can be directly dissipated from the substrate **8** to achieve better heat dissipating effect. However, the manufacturing procedure of such packaging structure of light-emitting diode is quite complicated. The surface of the substrate **8** must be first formed with the depression **81** by means of wet etching. Then the back face of the substrate **8** is formed with the electrode guide through holes **82** by means of dry etching or laser, which through holes **82** pass through the bottom of the depression **81.** Then the insulating layer is formed on the surface of the substrate **8.** Then the metal layer is deposited on the insulating layer to form the metal electrode and reflective layer in the depression. Then the metal electrode is cut into positive and negative electrode faces by means of laser. Especially, when making the electrode guide through holes **82,** it is necessary to form the electrode guide through holes **82** of the depressions **81** one by one. Mass-production is impossible so that the manufacturing cost is greatly increased.

Furthermore, the above packaging structures of the light-emitting diode are mainly used to manufacture single light-emitting diode. Such packaging structures are not applicable to array-type modularized structure. In array-type light-emitting diodes, the entire layout and convenience in electric connection with outer side must be considered. The above packaging structures of light-emitting diode both lack layout design adapted to modularization. Therefore, it is impossible to manufacture array-type modularized structure.

US-B1-6 614 103 and JP 11 161197A disclose LED array modules on a lower substrate provided with arrayed dents and covered by an upper substrate, wherein the LED crystals are fixed to and electrically connected through the arrayed dents.

### SUMMARY OF THE INVENTION

The packaging method for an arrayed modularized light-emitting diode structure according to the present invention is defined in claim 1. Further advantageous features are set out in the dependent claims.

The present invention can be best understood through the following description and accompanying drawings wherein:

### BRIEF DESCRIPTION OF THE DRAWINGS

Fig. 1 is a perspective view of the modularized structure formed by the method of the present invention;
Fig. 2 is a sectional view of a part of the modularized structure formed by the method of the present invention;
Fig. 3 is a diagram showing the circuit layout card of the lower substrate formed by the method of the present invention;
Figs. 4 to 4F show seven steps of manufacturing the upper substrate formed by the method of the present invention;
Figs. 5 to 5C show four steps of manufacturing the lower substrate, formed by the method of the present invention;
Fig. 6 shows the step of fixing the upper and lower substrates formed by the method of the present invention;
Fig. 7 shows the step of fixing the light-emitting diode crystallite formed by the method of the present invention;
Fig. 8 shows the dents of the upper substrate sealed by the protective board formed by the method of the present invention;
Fig. 9 shows the dents of the upper substrate sealed by transparent resin formed by the method of the present invention;
Fig. 10 shows the light-emitting diode crystallite with two electrodes positioned on the same side, fixed in the dent formed by the method of the present invention;
Fig. 11 shows the conductive materials used as the electrode pins of the light-emitting diode crystallite of the present invention;
Fig. 11A is a view according to Fig. 11, showing the electrode pins of the light-emitting diode crystallite of Fig. 11 electrically connected with the contact electrodes of the lower substrate formed by the method of the present invention;
Fig. 12 shows the light-emitting diode crystallite with two electrodes positioned on the other same side, fixed in the dent formed by the method of the present invention;
Fig. 13 shows three light-emitting diode crystallites disposed in each dent formed by the method of the present invention;
Fig. 14 shows the packaging structure of a conventional light-emitting diode; and
Fig. 15 shows another type of packaging structure of a conventional light-emitting diode.

### DETAILED DESCRIPTION OF THE PREFERRED EMBODIMENTS

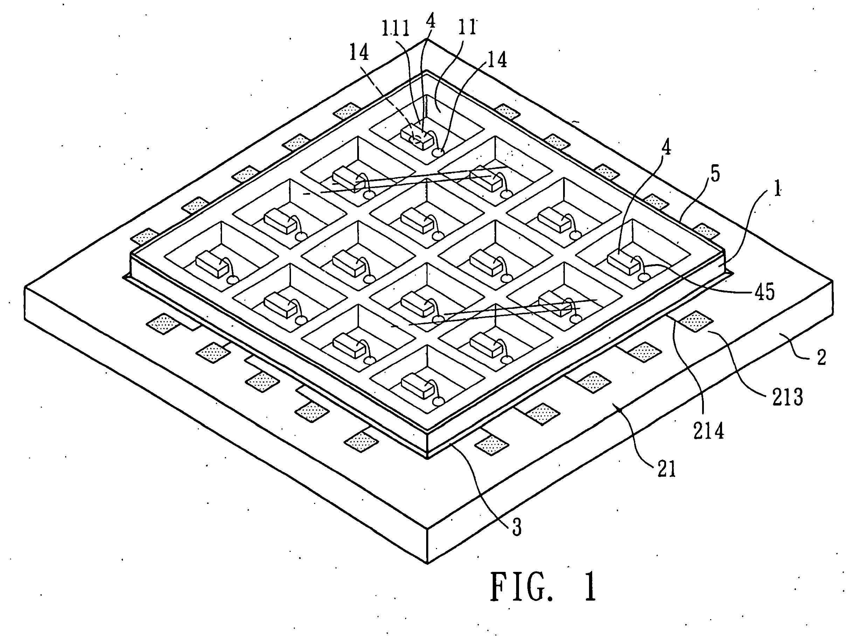

Please refer to Figs. 1 to 3. The array-type modularized light-emitting diode structure formed by the method of the present invention includes a lower substrate **2** and an upper substrate **1** fixed on a surface of the lower substrate **2.**

The upper substrate **1** has a certain high heat conductivity. Multiple arrayed dents **11** are formed in the upper substrate **1.** In this embodiment, multiple dents **11** are formed in the upper substrate **1** and arranged in a 4 x 4 array. Each dent **11** has a wall **112** inclined by a certain angle, whereby the dent **11** is tapered for enhancing reflection effect. Alternatively, the wall **112** of the dent **11** can be vertical or round. Each dent **11** has a bottom **111** formed with at least two through holes **12** passing through the bottom **111.** A conductive material **14** is disposed in each through hole **12.** At least one light-emitting diode crystallite **4** is fixed on the bottom **111** of each dent **11.** Each light-emitting diode crystallite **4** has two electrodes **41, 42.** The dents **11** of the upper substrate **1** are sealed to protect the light-emitting diode crystallites **4** from being oxidized.

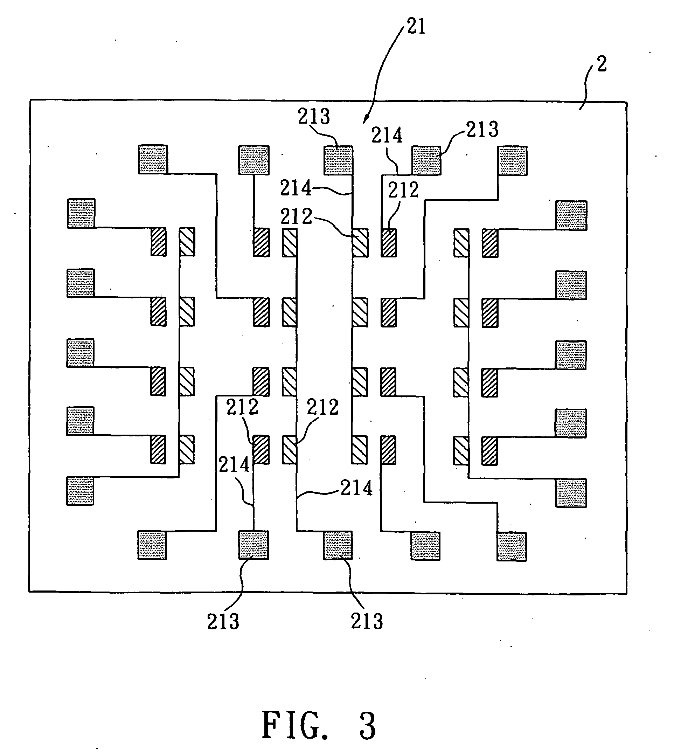

The lower substrate **2** has a certain high heat conductivity. A surface of the lower substrate **2** is formed with a predetermined circuit layout card **21** as shown in Fig. 3. The circuit layout card **21** has contact electrodes **212** respectively corresponding to the through holes **12** of the dents **11** of the upper substrate **1.** Via the conductive materials **14** in the through holes **12,** the contact electrodes **212** respectively electrically contact with the electrodes **41, 42** of the light-emitting diode crystallites **4.** In addition, the circuit layout card **21** has multiple connecting sections **213** along the periphery of the lower substrate **2** for connecting with outer side. The circuit layout card **21** further has conductive wires **214** between the contact electrodes **212** and the connecting sections **213.** In addition to the circuit layout card **21,** other microelectronic cells such as resistors, thermosensors and duplex diodes can be disposed on the surface of the lower substrate **2** for enhancing the function of the entire modularized controlling circuit.

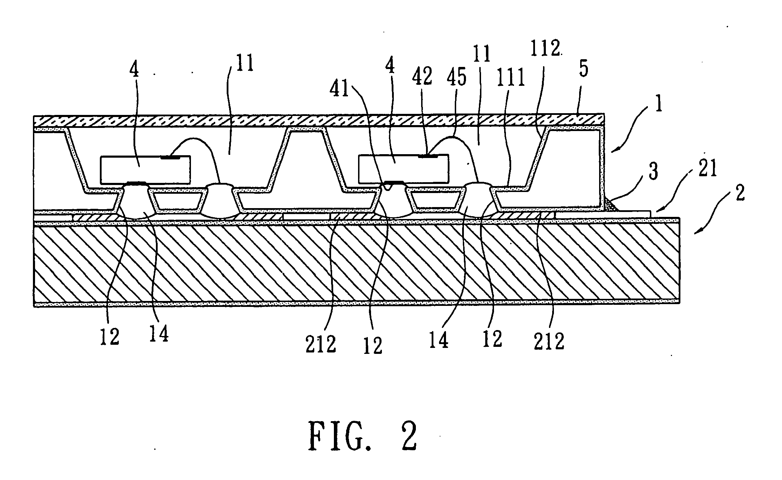

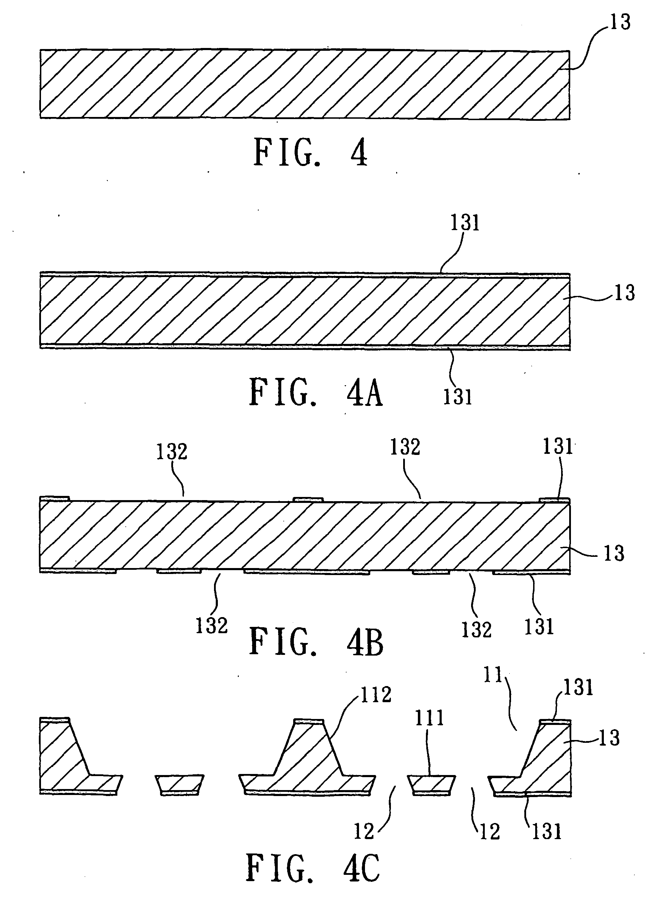

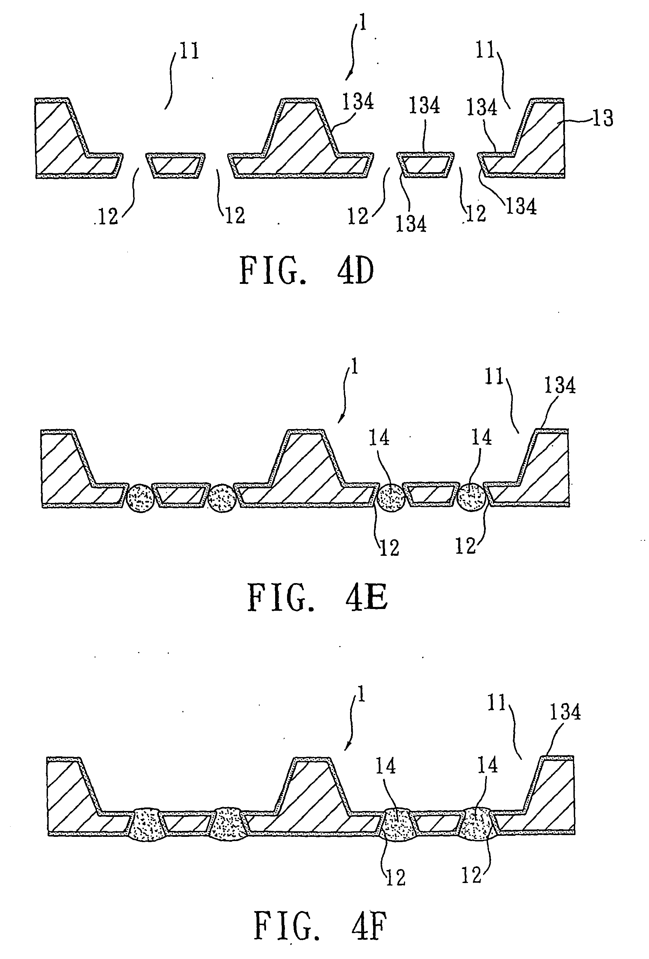

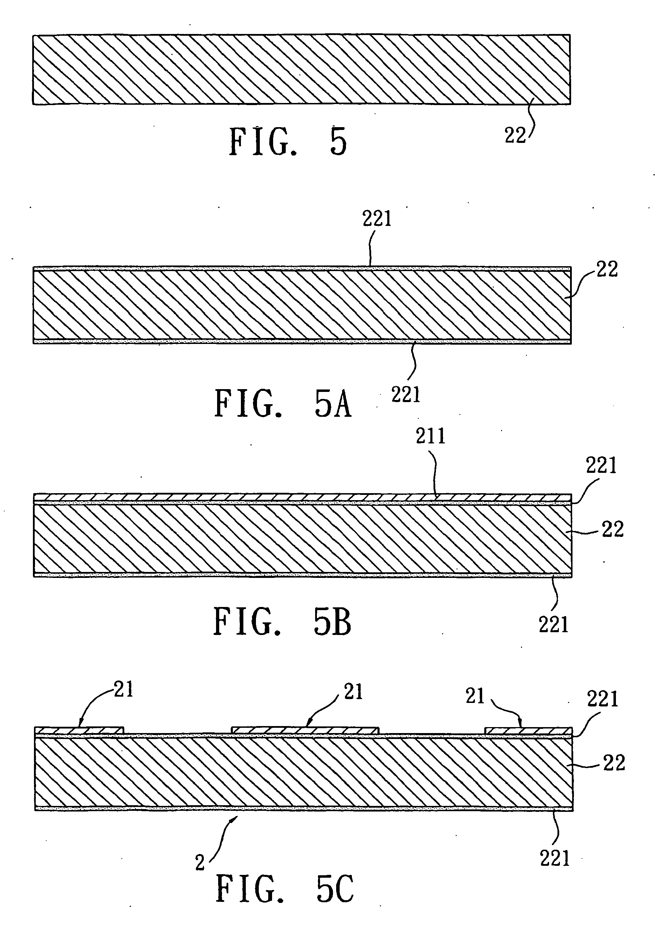

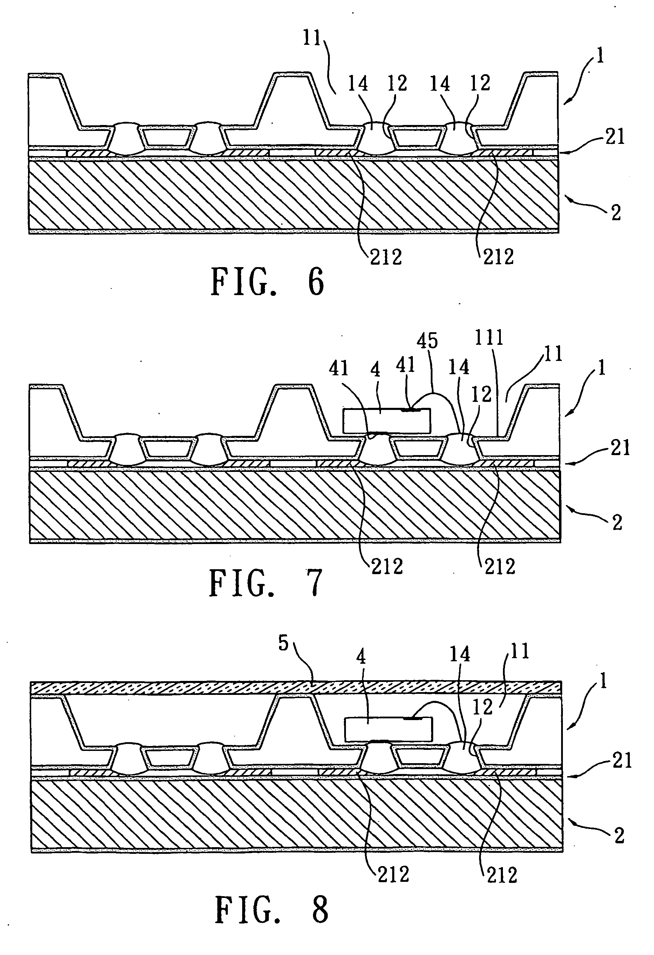

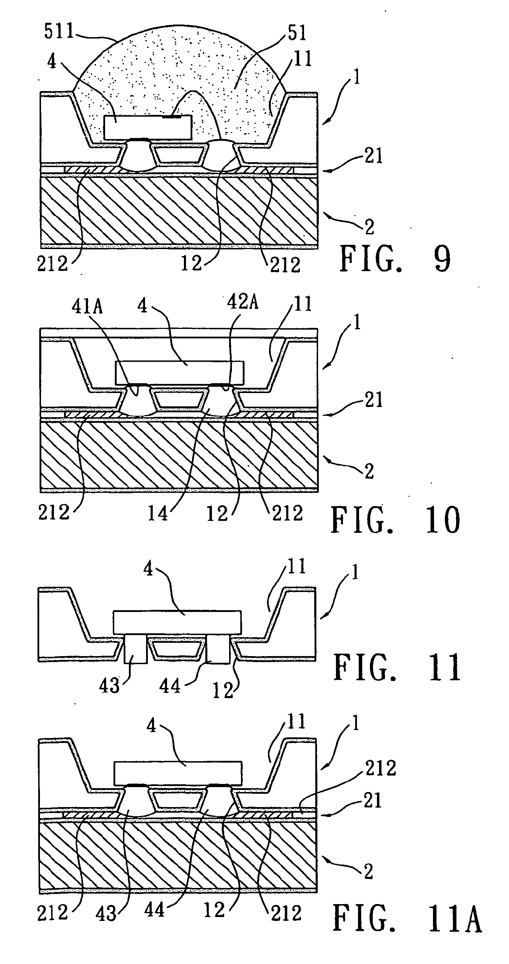

According to the present invention, in which one single light-emitting diode crystallite is packaged in each dent, the method for packaging the array-type modularized light-emitting diode structure of the present invention includes steps of:
manufacturing upper substrate, a material with high heat conductivity being selected as the material of the upper substrate, by means of one of molding, injection molding and etching, the upper substrate being made from the material to have multiple arrayed dents **11** and through holes **12,** in this embodiment, the upper substrate being made by means of etching, as shown in Figs. 4 to 4D, a single-crystal silicon chip **13** being selected as the material of the upper substrate **1,** the single-crystal silicon chip **13** being placed in a furnace and thermally oxidized to respectively grow two layers of silicon dioxide (or deposit two layers of silicon nitrite) on upper face and lower face of the single-crystal silicon chip **13** as etching-protective layers **131,** the etching regions **132** of the upper and lower faces of the single-crystal silicon chip **13** being defined by means of micro-image manufacturing procedure, the protective layers **131** within the etching regions **132** being removed by means of wet etching (BOE) or dry etching (RIE) to expose the etching regions **132** to outer side, then, by means of non-isotropic wet etching (KOH), the etching regions **132** being etched to a certain depth so as to simultaneously form multiple arrayed dents **11** in the single-crystal silicon chip **13** and at the same time form two through holes **12** on the bottom **111** of each dent **11,** then, the single-crystal silicon chip **13** with the dents **11** and through holes **12** being placed into the furnace to be heated and thermally oxidized to grow a layer of silicon dioxide (or deposit a layer of silicon nitrite) on the surface of each of the dents **11** and through holes **12** as an insulating layer **134**;
manufacturing lower substrate, a material with high heat conductivity being selected as the material of the lower substrate, by means of one of halftone printing and micro-image etching, the surface of the lower substrate **2** being formed with a predetermined circuit layout card **21,** in this embodiment, as shown in Figs. 5 to 5C, a single-crystal silicon chip **22** being selected as the material of the lower substrate **2,** the single-crystal silicon chip **22** being placed in a furnace, heated and thermally oxidized to respectively grow two layers of silicon dioxide (or deposit two layers of silicon nitrite) on upper face and lower face of the single-crystal silicon chip **22** as insulating layers **221,** then a metal layer **211** being deposited on the surface of the single-crystal silicon chip **22** by means of vapor deposition (or sputtering) as a substrate layer of the circuit layout card **21,** then the regions of the metal layer **211** to be etched for forming the circuit layout card **21** being defined by means of micro-image manufacturing procedure, the metal layer outside the regions being removed by means of etching so as to form the circuit layout card **21** with contact electrodes **212,** connecting sections **213** and conductive wires **214** on the surface of the lower substrate **2,** in the case that it is desired to further manufacture microelectronic cells necessary for the modularized controlling circuit on the surface of the lower substrate **2,** the microelectronic cells being formable by means of CMOS and relevant manufacturing procedures to integrate the cells and combine the system;
fixing the upper and lower substrates with each other, the bottom face of the upper substrate **1** being placed on the upper face of the lower substrate **2** as shown in Figs. 2, 3 and 6, the through holes **12** of the dents **11** of the upper substrate **1** respectively corresponding to the contact electrodes **212** of the circuit layout card **21** of the lower substrate **2,** the connecting sections **213** of the circuit layout card **21** being exposed to the periphery of the upper substrate **1,** then the upper and lower substrates **1, 2** being fixed with each other, in this embodiment, the peripheries of the upper and lower substrates **1, 2** in contact with each other being painted with a polymer material such as epoxy and polyimide or other adhesive material **3** such as UV glue to fix the upper and lower substrates **1, 2** with each other, the adhesive material **3** also serving to prevent humidity from infiltrating into the dents **11** of the upper substrate **1;**
fixing the light-emitting diode crystallites, multiple light-emitting diode crystallites **4** being respectively fixed on the bottoms **111** of the dents **11** of the upper substrate **1,** via the through holes **12** of the bottoms **111** of the dents **11,** the electrodes **41, 42** of the light-emitting diode crystallites **4** being electrically connected with the contact electrodes **212** of the circuit layout card **21** of the lower substrate **2,** in this embodiment, after forming the insulating layers **134** on the surfaces of the dents **11** and through holes **12** of the upper substrate **1,** as shown in Figs. 4E and 4F, conductive materials **14** such as tin balls (or conductive glue) being respectively implanted into the through holes **12** of the dents **11,** in this embodiment, the conductive materials **14** being tin balls, the upper substrate **1** being placed into a baker and heated to soften the tin balls **14** and fill up the through holes **12** with the tin, the tin balls **14** slightly protruding from two ends of the through holes **12** as shown in Fig. 7, whereby when the upper substrate **1** is fixed on the lower substrate **2** and when fixing the light-emitting diode crystallites **4,** the tin balls **14** contact with the electrodes **41, 42** of the light-emitting diode crystallites **4** and the contact electrodes **212** of the circuit layout card **21** so as to electrically connect the electrodes **41, 42** of the light-emitting diode crystallites **4** with the contact electrodes **212** of the circuit layout card **21** of the lower substrate **2;** and
sealing the dents of the upper substrate, the dents **11** of the upper substrate **1** being sealed to prevent the light-emitting diode crystallites **4** from being oxidized, in this embodiment, as shown in Fig. 8, in condition of vacuum or filling of a gas other than air, a protective board **5** such as a transparent glass board or acrylic board with good transparency being fixed on the surface of the upper substrate **1** to cover the same, the protective board **5** serving to isolate the light-emitting diode crystallites **4** from outer environment and protect the light-emitting diode crystallites **4** from being oxidized as well as avoid scatter of the light, an inner face of the protective board 5 being painted with fluorescent agent corresponding to the dents **11** so as to change the color of light emitted from the light-emitting diode crystallites **4,** in addition, the inner and outer faces of the protective board **5** being directly formed with convex lenses corresponding to the dents **11** for enhancing light-focusing or light-diverging effect. Alternatively, as shown in Fig. 9, by means of point-gluing, transparent resin **51** can be filled into the dents **11** to protect the light-emitting diode crystallites **4** from being oxidized. Moreover, in order to enhance focusing effect, the transparent resin **51** can be formed with a dome body **511.**

The array-type modularized light-emitting diode structure and the packaging method of the present invention are applicable to the light-emitting diode with two electrodes positioned on different sides and the light-emitting diode with two electrodes positioned on the same side. With respect to the light-emitting diode with two electrodes positioned on different sides, in the step of fixing the light-emitting diode crystallites, the bottom electrode **41** of the light-emitting diode crystallite **4** is fixed on a through hole **12** of the dent **11** as shown in Fig. 7 to electrically contact with the conductive material **14** in the through hole **12.** The top electrode **42** of the light-emitting diode crystallite **4** via a conductive wire **45** is connected with the conductive material **14** of the other through hole 12. Accordingly, the two electrodes **41, 42** of the light-emitting diode crystallite **4** are electrically connected with the contact electrodes **212** of the circuit layout card **21** of the lower substrate **2.**

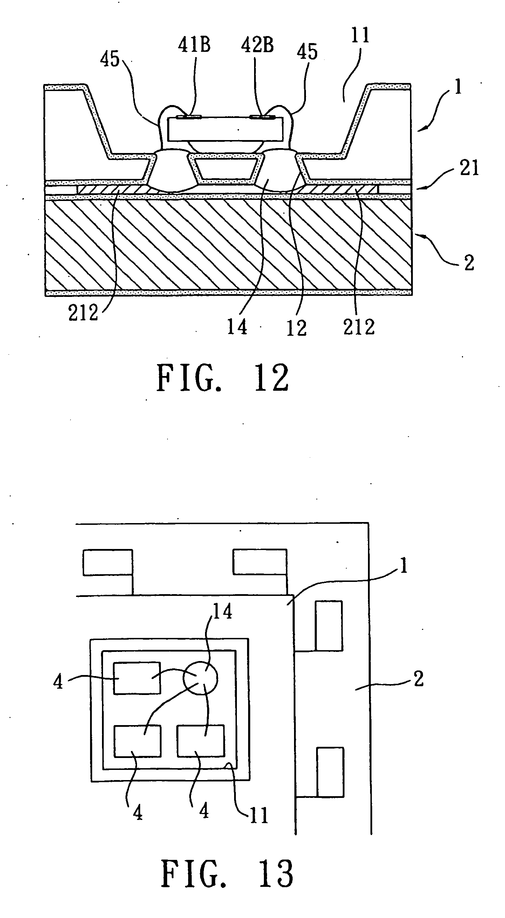

With respect to the light-emitting diode with two electrodes positioned on the same side, in the step of fixing the light-emitting diode crystallites, as shown in Fig. 12, the face of the light-emitting diode crystallite **4** opposite to the two electrodes **41B, 42B** is fixed between the through holes **12** of the dent **11.** Then the electrodes **41B**, **42B** on the same side of the light-emitting diode crystallite **4** via conductive wires **45** are connected with the conductive materials **14** in the through holes **12.** Accordingly, the two electrodes **41B, 42B** of the light-emitting diode crystallite **4** are electrically connected with the contact electrodes **212** of the circuit layout card **21** of the lower substrate **2.**

In the step of manufacturing upper substrate, a single-crystal silicon chip is selected as the material of the upper substrate **1** and etched to form the dents **11** by means of KOH. Therefore, the wall **112** of the dent **11** is inclined by an inclination of 54.74°. The dent **11** is tapered for reflecting the light. In addition, a reflective metal layer is deposited on the wall **112** of the dent **11** for enhancing the brightness of the light-emitting diode. A round dent can be formed by means of isotropic etching. This can also achieve light-reflecting effect.

In the above embodiment, a light-emitting diode is disposed in each dent. Alternatively, more than two light-emitting diode crystallites with red, green and blue colors of light can be disposed in each dent as shown in Fig. 13. Such structure can serve as a backlight source of a liquid crystal display panel.

According to the above arrangement, the array-type modularized light-emitting diode structure and the packaging method formed by the method of the present invention have the following advantages:
1. The material of the upper and lower substrate is a material with high heat conductivity and the light-emitting diode crystallites are fixed on the bottoms of the dents of the upper substrate. The heat generated by the light-emitting diode crystallites can dissipate from the upper and lower substrates so that the heat-dissipating effect is better. Accordingly, the lighting efficiency of the light-emitting diode can be enhanced.
2. Multiple light-emitting diodes are arrayed and modularized so that the present invention is applicable to those products necessitating modularized light-emitting diodes, such as car headlight, traffic sign and liquid crystal display panel. Moreover, via the circuit layout card of the lower substrate, the electrodes of the light-emitting diodes are guided to the periphery of the lower substrate for easily manufacturing the leads for connecting with outer side. This facilitates the successive packaging of the entire module.
3. In the step of manufacturing upper and lower substrates, the single-crystal silicon chip is used as the substrate board. Therefore, in cooperation with CMOS manufacturing procedure, a high-density modularized product can be manufactured. In addition, mass-production becomes possible so that the manufacturing cost can be greatly reduced.
4. In the step of manufacturing upper and lower substrates, the through holes are formed by means of etching and the internal conductive wires are made by means of meiting tin balls (or filling conductive glue). Therefore, the steps of the manufacturing procedure are reduced and simplified. Accordingly, the ratio of good products is increased and the manufacturing cost is lowered.
5. In the step of manufacturing upper and lower substrates, the single-crystal silicon chip is used as the substrate board. In comparison with other non-metal material, the silicon chip has higher heat conductivity. Moreover, with the silicon chip serving as the substrate board, the mechanical properties of the silicon chip are close to those of the material of the light-emitting diode so that the thermal stress damage of the cells caused by temperature effect can be reduced in use of the entire module.
6. In the step of sealing the dents of the upper substrate, all the dents can be sealed at one time by one single piece of glass. Therefore, the manufacturing procedure is simplified. Moreover, the fluorescent agent painted on the back face of the glass can change the color of the light emitted by the light-emitting diode.

The above embodiments are only used to illustrate the present invention, not intended to limit the scope thereof. Many modifications of the above embodiments can be made without departing from the scope of the present invention is defined in the appended claims.

## Claims

1. A method for packaging an array-type modularized light-emitting diode structure, comprising steps of:
manufacturing an upper substrate (1), a single-crystal silicon chip (13) being selected as the material of the upper substrate (1), by means of etching, wherein the single-crystal silicon chip (13) is placed in a furnace and heated to respectively form two etching-protective layers (131) on an upper face and a lower face of the single-crystal silicon chip (13), wherein the etching regions of the dents (11) and through holes (12) of the upper and lower faces of the single-crystal silicon chip (13) are defined by means of a micro-image manufacturing procedure, wherein the protective layers of the etching regions are removed by means of etching to expose the etching regions to the outer side, then, by means of non-isotropic wet etching, the etching regions are etched to a certain depth so as to simultaneously form multiple arrayed dents (11) in the single-crystal silicon chip (13) and at the same time form two through holes (12) on the bottom (111) of each dent (11), then, the single-crystal silicon chip (13) etched with the dents (11) and through holes (12) is placed into the furnace and heated to form an insulating layer (134), on the surface of each of the dents (11) and through holes (12), a tin ball (14) is implanted into each through hole (12) and then the upper substrate (1) is placed into a baker and heated to soften the tin ball (14) and to fill up the through hole (12) with the tin ball (14);
manufacturing a lower substrate (2), a material with high heat conductivity being selected as the material of the lower substrate (2), by means of one of halftone printing and etching, a surface of the lower substrate (2) being formed with a predetermined circuit layout card (21), the circuit layout card (21) having multiples contact electrodes (212) and multiple connecting sections (213) along a periphery of the lower substrate (2) for connecting with outer side, the circuit layout card (21) further having conductive wires (45) between the contact electrodes (212) and the connecting sections (213);
placing the bottom face of the upper substrate (1) on the upper face of the lower substrate (2) with the through holes (12) of the dents (11) of the upper substrate (1) respectively corresponding to the contact electrodes (212) of the circuit layout card (21) of the lower substrate (2), the connecting sections (213) of the circuit layout card (21) being exposed to the periphery of the upper substrate (1), then fixing the upper and lower substrates (2) to each other;
fixing multiple light-emitting diode crystallites (4) respectively on the bottoms (111) of the dents (11) of the upper substrate (1), via the through holes (12) of the bottoms (111) of the dents (11), the electrodes of the light-emitting diode crystallites (4) being electrically connected with the contact electrodes (212) of the circuit layout card (21) of the lower substrate (2); and
sealing the dents (11) of the upper substrate (1) in order to prevent the light-emitting diode crystallites (4) from being oxidized.

2. The method of claim 1, wherein in the step of manufacturing lower substrate (2), a single-crystal silicon chip (22) is selected as the material of the lower substrate (2), wherein the single-crystal silicon chip (22) is placed in a furnace and heated to respectively form two insulating layers on upper face and lower face of the single-crystal silicon chip (22), then a metal layer is deposited on the upper face of the single-crystal silicon chip (22) by means of vapor deposition as a substrate layer of the circuit layout card (21), then the regions of the metal layer to be etched for forming the circuit layout card (21) are defined by means of micro-image manufacturing procedure, the metal layer outside the regions is removed by means of etching so as to form the circuit layout card (21) with the contact electrodes (212), connecting sections (213) and conductive wires (45) on the upper face of the lower substrate (2).

3. The method of claim 1, wherein in the step of sealing the dents (11) of the upper substrate (1), in condition of vacuum, a protective board (5) with good transparency is fixed on the surface of the upper substrate (1) to cover the upper substrate (1) and to isolate the light-emitting diode crystallites (4) from outer environment.

## Patentansprüche

1. Verfahren zur Verpackung einer feldartigen, modularisierten Leuchtdiodenstruktur, bei dem
ein oberes Substrat (1), für das ein Monokristallsiliciumchip (13) als Material ausgewählt ist, durch Ätzen hergestellt wird, wobei
der Monokristallsiliciumchip (13) in einen Ofen gelegt und erhitzt wird, um zwei Ätzschutzschichten (131), jeweils eine an einer Ober- und an einer Unterseite des Monokristallsiliciumchips (13), zu bilden,
die Ätzbereiche der Vertiefungen (11) und Durchgangslöcher (12) der Ober- und der Unterseite des Monokristallsiliciumchips (13) durch ein Mikrobildherstellungsvorgang definiert werden,
die Schutzschichten der Ätzbereiche durch Ätzen entfernt werden, um die Ätzbereiche nach außen frei zu legen,
dann durch anisotropisches Nassätzen die Ätzbereiche auf eine bestimmte Tiefe geätzt werden, um im Monokristallsiliciumchip (13) gleichzeitig mehrere feldartige Vertiefungen (11) und gleichzeitig am Boden (111) jeder Vertiefung (11) zwei Durchgangslöcher (12) zu bilden,
dann der Monokristallsiliciumchip (13) mit den ausgeätzten Vertiefungen (11) und den Durchgangslöchern (12) in den Ofen gelegt und erhitzt wird, damit sich auf der Oberfläche jeder Vertiefung (11) und der Durchgangslöcher (12) eine Isolationsschicht (134) bildet,
in jedes Durchgangsloch (12) eine Zinnkugel (14) eingesetzt wird und
dann das obere Substrat (1) in ein Backgerät gelegt und erhitzt wird, um die Zinnkugeln (14) aufzuweichen und die Durchgangslöcher (12) mit den jeweiligen Zinnkugeln (14) aufzufüllen;
entweder durch Druckrasterverfahren oder Ätzen ein unteres Substrat (2), für das ein Material mit hoher Wärmeleitfähigkeit ausgewählt ist, hergestellt wird, wobei
eine Fläche des unteren Substrates (2) mit einer vorbestimmten Schaltungsauslegungskarte (21) gebildet wird und
die Schaltungsauslegungskarte (21) entlang eines Randes des unteren Substrates (2) mehrere Kontaktelektroden (212) und mehrere Verbindungsabschnitte (213) zum Verbinden mit der Außenseite aufweist, wobei die Schaltungsauslegungskarte (21) zwischen den Kontaktelektroden (212) und den Verbindungsabschnitten (213) ferner Leitungen (45) aufweist;
die Unterseite des oberen Substrates (1) auf die Oberseite des unteren Substrates (2) gesetzt wird, wobei
die Durchgangslöcher (12) der Vertiefungen (11) des oberen Substrates (1) jeweils den Kontaktelektroden (212) der Schaltungsauslegungskarte (21) des unteren Substrates (2) entsprechen,
die Verbindungsabschnitte (213) der Schaltungsauslegungskarte (21) zur Umgebung des oberen Substrates (1) freiliegen,
dann das obere und das untere Substrat (2) aneinander befestigt werden;
über die Durchgangslöcher (12) der Böden (111) der Vertiefungen (11) jeweils an den Böden (111) der Vertiefungen (11) des oberen Substrates (1) mehrere Leuchtdiodenkristalle (4) angebracht werden,
wobei die Elektroden der Leuchtdiodenkristalle (4) mit den Kontaktelektroden (212) der Schaltungsauslegungskarte (21) des unteren Substrates (2) elektrisch verbunden werden und
die Vertiefungen (11) des oberen Substrates (1) abgedichtet werden um die Leuchtdiodenkristalle (4) vor Oxidierung zu schützen.

2. Verfahren nach Anspruch 1, bei dem beim Herstellen des unteren Substrates (2) ein Monokristallsiliciumchip (22) als Material des unteren Substrates (2) ausgewählt ist, wobei
der Monokristallsiliciumchip (22) in einen Ofen gelegt und erhitzt wird, um zwei Isolierschichten, jeweils eine an Ober- und Unterseite des Monokristallsiliciumchips (22), zu bilden,
dann an der Oberseite des Monokristallsiliciumchip (22) eine Metallschicht als Substratschicht der Schaltungsauslegungskarte (21) aufgedampft wird
dann die Bereiche der zu ätzenden Metallschicht zum Bilden der Schaltungsauslegungskarte (21) durch ein Mikrobildherstellungsvorgang definiert werden und
die Metallschicht außerhalb der Regionen durch Ätzen entfernt wird, um so auf der Oberseite des unteren Substrates (2) die Schaltungsauslegungskarte (21) mit den Kontaktelektroden (212), den Verbindungsabschnitten (213) und den Leitungen (45) zu bilden.

3. Verfahren nach Anspruch 1, bei dem beim Abdichten der Vertiefungen (11) des oberen Substrates (1) an der Oberfläche des oberen Substrates (1) unter Vakuum eine Schutzplatte (5) mit hoher Transparenz angebracht wird, um das obere Substrat (1) abzudecken und die Leuchtdiodenkristalle (4) von der äußeren Umwelt zu isolieren.

## Revendications

1. Procédé de conditionnement d'une structure de diode électroluminescente modulaire de type réseau, comprenant les étapes consistant à:
fabriquer un substrat supérieur (1), une puce de silicium monocristallin (13) étant choisie comme matériau du substrat supérieur (1), au moyen d'un procédé de gravure, dans lequel la puce de silicium monocristallin (13) est placée dans un four et chauffée pour former respectivement deux couches de protection de gravure (131) sur une face supérieure et une face inférieure de la puce de silicium monocristallin (13), dans lequel les zones de gravure des creux (11) et des trous traversants (12) des faces supérieure et inférieure de la puce de silicium monocristallin (13) sont définies au moyen d'une procédure de fabrication de micro-image, dans lequel les couches de protection des zones de gravure sont retirées par gravure de sorte à exposer les zones de gravure au côté externe, puis au moyen d'une gravure humide non isotrope, les régions de gravure sont gravées à une certaine profondeur de manière à former simultanément de multiples creux en réseau (11) dans la puce de silicium monocristallin (13) et à former en même temps deux trous traversants (12) sur le fond (111) de chaque creux (11), puis, la puce de silicium monocristallin (13) gravée avec les creux (11) et les trous traversants (12) est placée dans le four et chauffée de manière à former une couche isolante (134) sur la surface de chacun des creux (11) et des trous traversants (12), une bille en étain (14) est implantée dans chaque trou traversant (12) et le substrat supérieur (1) est ensuite placé dans un appareil de cuisson et chauffé pour ramollir la bille en étain (14) et pour remplir le trou traversant (12) avec la bille en étain (14) ;
fabriquer un substrat inférieur (2), un matériau à conductivité thermique élevée étant choisi comme matériau du substrat inférieur (2), au moyen de l'une d'une impression en simili et d'une gravure, une surface du substrat inférieur (2) étant formée avec une carte d'agencement de circuit prédéterminée (21), la carte d'agencement de circuit (21) ayant de multiples électrodes de contact (212) et de multiples sections de connexion (213) le long d'une périphérie du substrat inférieur (2) pour connexion avec le côté externe, la carte d'agencement de circuit (21) ayant en outre des fils conducteurs (45) entre les électrodes de contact (212) et les sections de connexion (213) ;
placer la face inférieure du substrat supérieur (1) sur la surface supérieure du substrat inférieur (2) avec les trous traversants (12) des creux (11) du substrat supérieur (1) correspondant respectivement aux électrodes de contact (212) de la carte d'agencement de circuit (21) du substrat inférieur (2), les sections de connexion (213) de la carte d'agencement de circuit (21) étant exposées à la périphérie du substrat supérieur (1), puis fixer les substrats supérieur et inférieur (2) l'un à l'autre ;
fixer les multiples cristallites de diode électroluminescente (4) respectivement sur les fonds (111) des creux (11) du substrat supérieur (1), via les trous traversants (12) des fonds (111) des creux (11), les électrodes des cristallites de diode électroluminescente (4) étant connectées électriquement aux électrodes de contact (212) de la carte d'agencement de circuit (21) du substrat inférieur (2) ; et
assurer l'étanchéité des creux (11) du substrat supérieur (1) afin d'empêcher les cristallites de diode électroluminescente (4) de s'oxyder.

2. Procédé selon la revendication 1, dans lequel dans l'étape consistant à fabriquer le substrat inférieur (2), une puce de silicium monocristallin (22) est choisie comme matériau du substrat inférieur (2), dans lequel la puce de silicium monocristallin (22) est placée dans un four et chauffée pour former respectivement deux couches isolantes sur la face supérieure et la face inférieure de la puce de silicium monocristallin (22), puis une couche métallique est déposée sur la face supérieure de la puce de silicium monocristallin (22) au moyen d'un dépôt par évaporation sous vide en tant que couche de substrat de la carte d'agencement de circuit (21), puis les régions de la couche métallique devant être gravées pour former la carte d'agencement de circuit (21) sont définies au moyen de la procédure de fabrication de micro-image, la couche métallique à l'extérieur des régions est retirée par gravure de manière à former la carte d'agencement de circuit (21) avec les électrodes de contact (212), les sections de connexion (213) et les fils conducteurs (45) sur la face supérieure du substrat inférieur (2).

3. Procédé selon la revendication 1, dans lequel dans l'étape consistant à assurer l'étanchéité des creux (11) du substrat supérieur (1), en condition de vide, une carte de protection (5) de bonne transparence est fixée sur la surface du substrat supérieur (1) pour couvrir le substrat supérieur (1) et pour isoler les cristallites de diode électroluminescente (4) de l'environnement externe.
